Europäisches Patentamt

European Patent Office

Office européen des brevets

(19)

(11) Publication number: **0 023 429**
**B1**

(12) **EUROPEAN PATENT SPECIFICATION**

(45) Date of publication of patent specification: **18.12.85**

(21) Application number: **80302564.2**

(22) Date of filing: **28.07.80**

(51) Int. Cl.⁴: **H 01 L 21/306,** H 01 L 21/31, H 01 L 21/28, C 23 F 1/12

(54) **Dry etching of metal film.**

(30) Priority: **31.07.79 JP 98201/79**
**31.07.79 JP 98202/79**
**31.07.79 JP 98203/79**

(43) Date of publication of application:
**04.02.81 Bulletin 81/05**

(45) Publication of the grant of the patent:
**18.12.85 Bulletin 85/51**

(84) Designated Contracting States:
**DE FR GB**

(56) References cited:
**GB-A-2 022 025**
**GB-A-2 026 394**
**US-A-4 030 967**

**IEEE, Technical Digest, Washington, 6th-8th December 1976, New York (USA); R.G. POULSEN et al.: "PLasma etching of aluminum", pages 205-207**

(73) Proprietor: **FUJITSU LIMITED**
**1015, Kamikodanaka Nakahara-ku**
**Kawasaki-shi Kanagawa 211 (JP)**

(72) Inventor: **Takada, Tadakazu**
**185-11-106, Taira Takatsu-ku**
**Kawasaki-shi Kanagawa 213 (JP)**
Inventor: **Tokitomo, Kazuo**
**260-12, Kitatakizawa Hachiman Itsukimachi Aizuwakamatsu-shi Fukushima 965 (JP)**
Inventor: **Hoshino, Hitoshi**
**1-24-9, Fujigaoka Midori-ku**
**Yokohama-shi Kanagwa 227 (JP)**

(74) Representative: **Allman, Peter John et al**
**Marks and Clerk Scottish Life House Bridge Street**
**Manchester M3 3DP (GB)**

Courier Press, Leamington Spa, England.

## Description

### Background of the invention

#### Field of the invention

The present invention relates to a process for dry etching an aluminium film or an aluminium based metal film.

The present invention may be advantageously applied to the formation of a conductor pattern from an aluminium film or an aluminium based film in the production of semiconductor devices.

#### Description of the prior art

Materials of a conductor pattern of a semiconductor device are generally aluminium and aluminium based metal including aluminium-copper, aluminium-silicon and aluminium-copper-silicon. The addition of copper to aluminium increases its electromigration resistance and the addition of silicon to aluminium prevents silicon depletion of shallow junctions.

In a case where a conductor pattern of a semiconductor device is formed by etching an aluminium film or an aluminium based film, dry etching, i.e. plasma etching, reactive ion etching and reactive sputter etching, is preferred to wet chemical etching for several reasons. For example, dry etching is cleaner, results in a smaller linewidth of the pattern, i.e. a film pattern, there are no noxious and polluting acids and solvents involved, and it is more economic than wet etching. Some etchant gases, for example, the following three kinds of gases have been proposed for the dry etching of an aluminium film and an aluminium based film.

(1) Mixed gas of carbon tetrachloride ($CCl_4$) and inert gas (He, Ar)

When dry etching of an aluminium film using this mixed gas is finished, a so-called "aluminium residue", which is aluminium oxide, tends to remain.

When an aluminium-copper film is dry etched with this mixed gas, the aluminium of the film is converted into aluminium trichloride ($AlCl_3$), which is volatile at approximately 130°C, and therefore, aluminium removal occurs. However, the copper compound of the film is volatile only at temperatures above 1000°C and, since the temperature does not exceed 150°C during the etching period, volatilizing of the copper compound does not occur. As a result, since copper residues accumulate during the dry etching and prevent further etching, it is difficult to etch an aluminium-copper film.

(2) Mixed gas of phosphorus trichloride ($PCl_3$) and boron trichloride ($BCl_3$)

This mixed gas ($PCl_3+BCl_3$) has the ability to cause chemical sputtering of a metal film to be etched and, therefore, it is possible to etch an aluminium film and an aluminium-copper film, and simultaneously, to remove aluminium residues and copper residues. However, phosphorus trichloride has strong corrosion tendency, easily reacts with moisture in the air to produce hydrochloric acid (HCl) and is labile. Furthermore, the permissible concentration range of the phosphorus trichloride is very narrow and depends on the dry etching conditions, such as the pressure inside the vacuum system, the power of the etching apparatus and the total pressure of the mixed gas. If the concentration of the phosphorus trichloride is outside the permissible range, satisfactory etching can not be performed. In addition, when each of an aluminium film and an aluminium based film is dry etched using this mixed gas, the mixed gas tends to undercut a masking film (i.e. a patterned photoresist film), namely, the etchant gas horizontally etches a portion of the aluminium or aluminium based film which is covered with the masking film.

(3) Boron trichloride ($BCl_3$) with or without oxygen ($O_2$)

When an aluminium film is etched using boron trichloride only, the aluminium etchrate (i.e. etching rate) is small, since the number of generated chloric radicals is small. The addition of oxygen to the boron trichloride increases the number of the generated chloric radicals, so that the aluminium etchrate increases, but undesirable undercutting occurs.

As mentioned above, each of the proposed etchant gases has demerits.

Furthermore, a person having an ordinary skill in the art might intend to use a fluorine gas being one of the halogen gases as the etchant gas. However, on an aluminium film to be etched an aluminium fluoride film is gradually formed, since the aluminium fluoride is not volatile at temperatures under 1260°C. The aluminium fluoride film serves as a passive film, so that further etching progress is not made.

An object of the present invention is to provide a dry etching process wherein a new etchant gas for etching an aluminium film and an aluminium based film is used.

Another object of the present invention is to provide a process for dry etching an aluminium film and an aluminium based film at relatively high etchrates.

A further object of the present invention is to form a fine conductor pattern of aluminium or aluminium based metal on a silicon chip.

In accordance with the present invention, there is provided a process for dry etching an aluminium film or an aluminium based metal film, comprising the step of exposing the film to an etchant gas, characterised in that the etchant gas is a mixture of carbon tetrachloride and boron trichloride, or a mixture of carbon

2

tetrachloride, boron trichloride and an inert gas as a carrier, the amount of inert gas being less than one half of the amount of boron trichloride.

It is preferable that the partial pressure of the carbon tetrachloride is in the range of from 30 to 80 percent of the total pressure of the mixed gas that the etchant gas has a pressure in the range of from 13.3 Pa to 33.3 Pa.

The invention also provides a process for forming a fine conductor pattern of aluminium on a silicon chip provided with a silicon dioxide film and in which a patterned masking film of photoresist is formed on the metal film, characterised in that the metal film is exposed to a mixed etchant gas of carbon tetrachloride and boron trichloride, or of carbon tetrachloride, boron trichloride and inert gas, to remove at least one half of the unmasked portion of the metal film, an aluminium oxide film is formed on the exposed surface of the metal film by a treatment in water, and the exposing step is repeated in the etchant gas to remove the horizontal portion of the aluminium oxide film and the rest of the unmasked portion of the metal film lying under the horizontal portion of the aluminium oxide film.

The invention further provides a process for forming a fine conductor pattern of aluminium based metal on a silicon chip provided with a silicon dioxide film and in which a patterned masking film of photoresist is formed on the metal film, characterised in that the metal film is exposed to a mixed etchant gas of carbon tetrachloride and boron trichloride, or carbon tetrachloride, boron trichloride and inert gas, to remove at least one half of the unmasked portion of the metal film and to accumulate residues of the metal film, the residues are removed by a remover, the aluminium oxide film is formed on the exposed surface of said metal film by a treatment in water, and repeating said exposing step to remove the horizontal portion of said aluminium oxide film and the rest of said unmasked portion of the metal film lying under said horizontal portion of the aluminium oxide film.

Brief description of the drawings

The above-mentioned and other objects and advantages of the present invention will become more apparent from the detailed description of preferred embodiments, set forth below, with reference to the accompanying drawings, wherein:

Fig. 1 is a diagram showing the relationship between the aluminium etchrate and partial pressure ratio of $CCl_4$ or $PCl_3$ with regard to three kinds of etchant gases;

Fig. 2 is a diagram showing the relationship between the aluminium etchrate and RF power with regard to the three kinds of etchant gases;

Fig. 3 is a diagram showing the relationship between the aluminium etchrate and total pressure of etchant gas with regard to the three kinds of etchant gases;

Fig. 4 is a diagram showing the relationship between the aluminium-copper etchrate and partial pressure ratio of $CCl_4$ or $PCl_3$ with regard to two kinds of etchant gases;

Fig. 5 is a diagram showing the difference between etchrates of various materials;

Fig. 6 is a diagram showing the relationship between the aluminium etchrate nonuniformity and total pressure of etchant gas;

Fig. 7 is a diagram showing the relationship between the aluminium etchrate nonuniformity and partial pressure of etchant gas;

Fig. 8 is a diagram showing the relationship between the etched thickness of a specimen and etching time;

Fig. 9a is a schematic sectional view of a portion of an overetched sample;

Fig. 9b is a diagram showing the relationship between the amount of undercutting of an aluminium film and the partial pressure ratio of $CCl_4$ or $PCl_3$ with regard to three kinds of etchant gases;

Fig. 9c is a diagram showing the relationship between the amount of undercutting of an aluminium-copper film and the partial pressure ratio of $CCl_4$ or $PCl_3$ with regard to two kinds of etchant gases;

Fig. 10a through 10d are schematic sectional views of a portion of a semiconductor device in various stages of production in accordance with an embodiment of the present inveniton, and;

Fig. 11a through 11d are schematic sectional views of a portion of a semiconductor device in various stages of production in accordance with another embodiment of the present invention.

Detailed description of the preferred embodiments

In order to compare the dry etching process of the present invention with dry etching process of the prior art, the following Experiments 1 through 9 were performed.

Experiment 1

High purity aluminium was etched in a conventional plasma etching apparatus under the following conditions, wherein the mixing ratio of each etchant gas was varied.

Etchant gas: $CCl_4+BCl_3$, $PCl_3+BCl_3$ or $CCl_4+He$

Total pressure of etchant gas: 26.7 Pa

RF power (frequency of RF power being 13.56 $MH_z$): 1 KW.

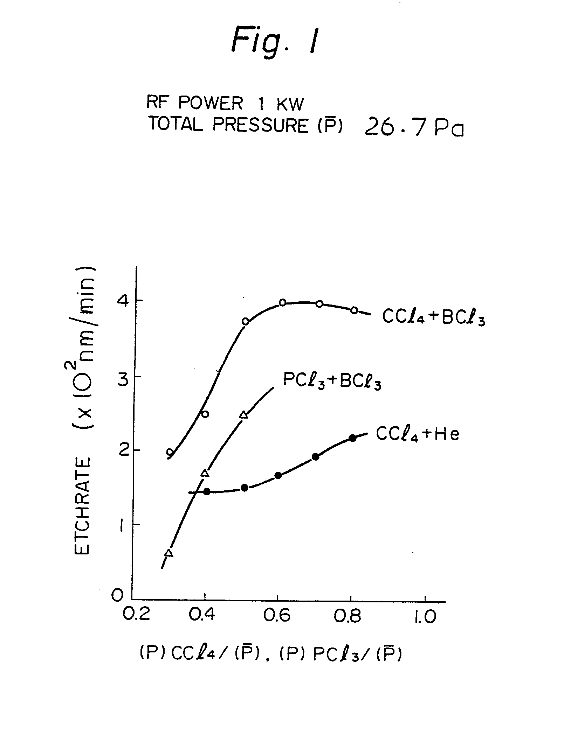

The results of the Experiment 1 are shown in Fig. 1, wherein the ordinate indicates the aluminium etchrate, and the abscissa indicates the ratio of partial pressure of $CCl_4$ or $PCl_3$ to the total pressure 26.7 Pa

3

of the etchant gas. As is evident from Fig. 1, the aluminium etchrate obtained by using the etchant gas (mixed gas) of $CCl_4$ and $BCl_3$ was higher than that obtained by using the mixed gas of $PCl_3$ and $BCl_3$ or the mixed gas of $CCl_4$ and He.

Experiment 2

High purity aluminium was etched in the plasma etching apparatus used in the Experiment 1 under the following conditions, wherein the RF power was varied.

Etchant gas: $CCl_4+BCl_3$, $PCl_3+BCl_3$ or $CCl_4+HE$

Total pressure of etchant gas: 26.7 Pa

Ratio of the partial pressure of $CCl_4$ or $PCl_3$ to the total pressure: 0.5

RF power: 400, 600, 800, and 1000 watts.

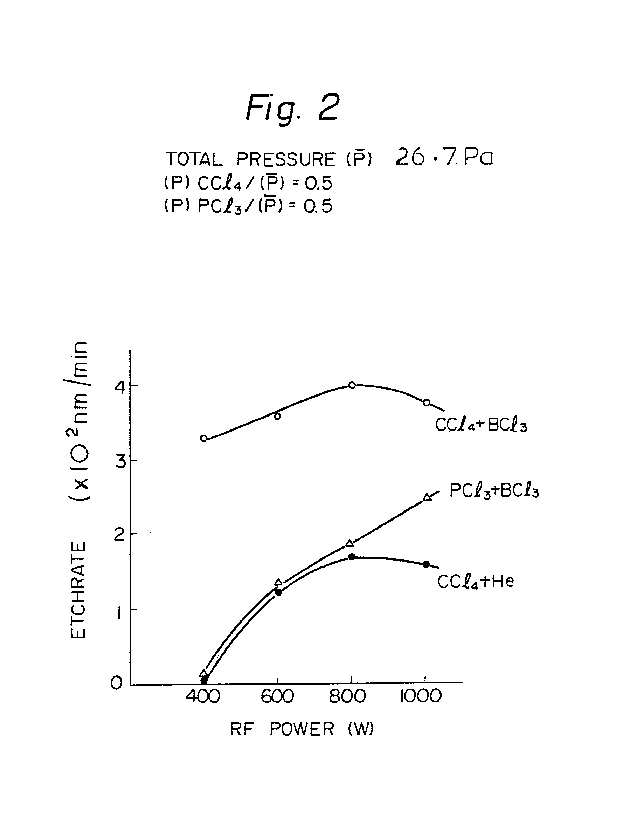

The results of the Experiment 2 are shown in Fig. 2. As is evident from Fig. 2, the aluminium etchrate obtained by using the mixed gas of $CCl_4$ and $BCl_3$ was higher than that obtained by using the mixed gas of $PCl_3$ and $BCl_3$ or the mixed gas of $CCl_4$ and He.

Experiment 3

High purity aluminium was etched in the plasma etching apparatus used in the Experiment 1 under the following conditions, wherein the total pressure of the each etchant gas was varied.

Etchant gas: $CCl_4+BCl_3$, $PCl_3+BCl_3$ or $CCl_4+He$

Total pressure of etchant gas: 13.3 Pa, 20.0 Pa, 26.7 Pa, 33.3 Pa, 40.0 Pa

Ratio of the partial pressure of $CCl_4$ or $PCl_3$ to the total pressure: 0.5

RF power: 1 KW.

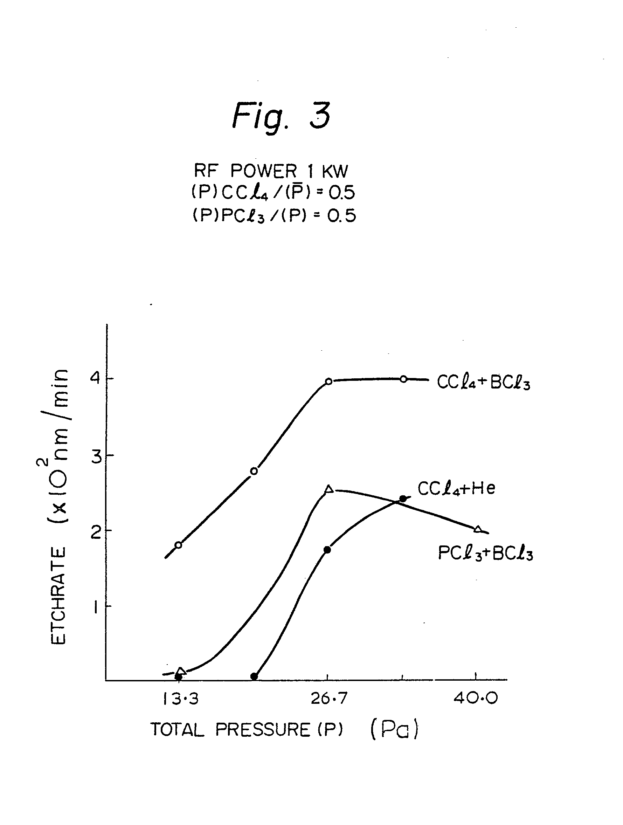

The results of the Experiment 3 are shown in Fig. 3. As is evident from Fig. 3, the aluminium etchrate obtained by using the mixed gas of $CCl_4$ and $BCl_3$ was higher than that obtained by using the mixed gas of $PCl_3$ and $BCl_3$ or the mixed gas of $CCl_4$ and He.

Experiment 4

Aluminium-copper (4 wt.%) metal was etched in the plasma etching apparatus used in the Experiment 1 under the following conditions, wherein the mixing ratio of each etchant gas was varied.

Etchant gas: $CCl_4+BCl_3$ or $PCl_3+BCl_3$

Total pressure of etchant gas: 26.7 Pa

RF power: 1 KW.

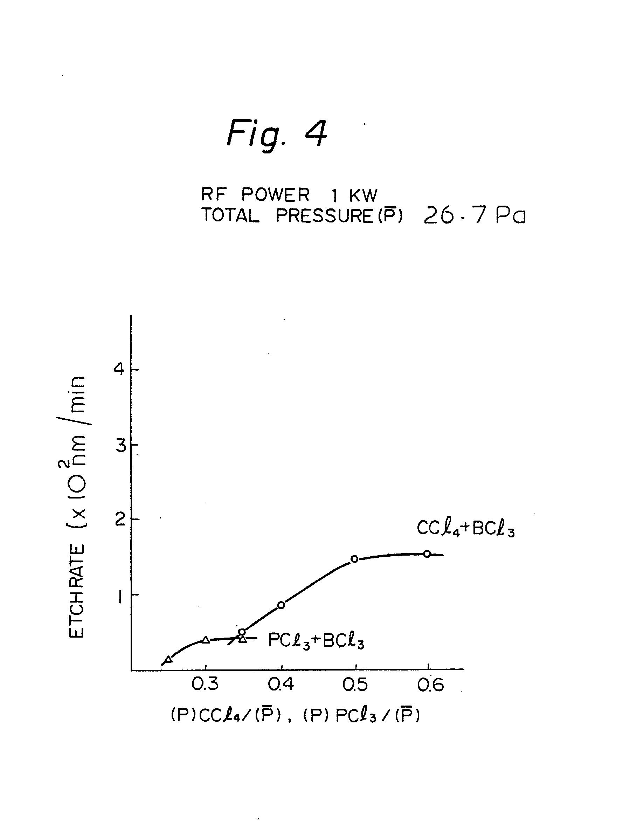

The results of the Experiment 4 are shown in Fig. 4. The aluminium-copper metal etchrate obtained by using the etchant gas of $CCl_4$ and $BCl_3$ was higher than that obtained by using the etchant gas of $PCl_3$ and $BCl_3$.

Experiment 5

In order to compare etchrates of silicon (Si), a negative type photoresist, silicon dioxide ($SiO_2$) and aluminium, a silicon wafer, a negative type photoresist film, a silicon dioxide film and an aluminium film were etched in the plasma etching apparatus used in the Experiment 1 under the following three conditions.

*Etching condition A (the present invention)

Etchant gas: $CCl_4+BCl_3$

Total pressure of the etchant gas: 26.7 Pa

Ratio of the partial pressure of $CCl_4$ to the total pressure: 0.5

RF power: 1 KW.

*Etching condition B (a comparative example)

Etchant gas: $CCl_4+He$

Total pressure of the etchant gas: 26.7 Pa

Ratio of the partial pressure of $CCl_4$ to the total pressure: 0.7

RF power: 1 KW.

*Etching condition C (another comparative example)

Etchant gas: $PCl_3+BCl_3$

Total pressure of the etchant gas: 26.7 Pa

Ratio of the partial pressure of $PCl_3$ to the total pressure: 0.5

RF power: 1 KW.

In this experiment the silicon was a (100) oriented single crystalline silicon, the negative type photoresist was OMR-83 (a product of Tokyo Ohka Kogyo) and the silicon dioxide was produced by thermal oxidizing silicon.

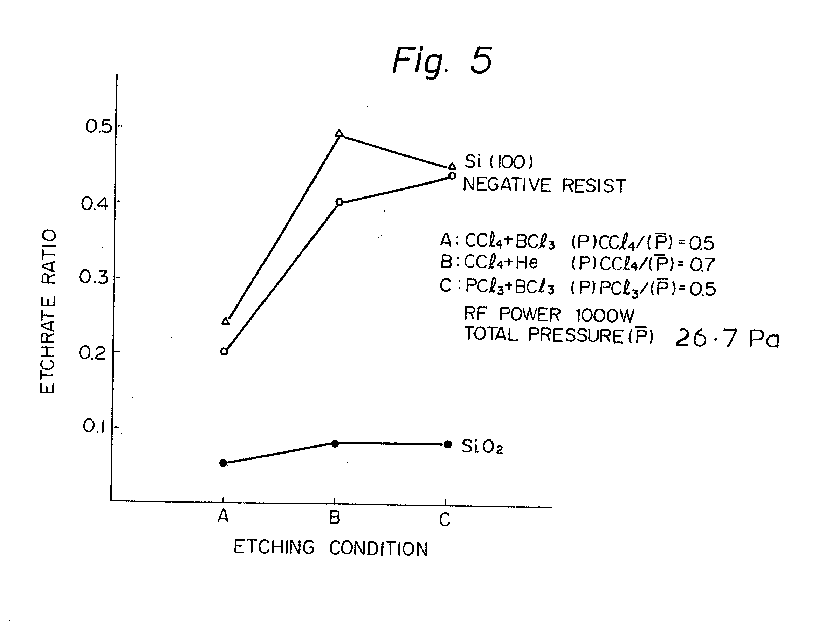

The results of the Experiment 5 are shown in Fig. 5, wherein the ordinate indicates the ratio of each of the etchrates of the silicon, photoresist and silicon dioxide to the aluminium etchrate the Experiment 1.

As is evident from Fig. 5, the etchrates of the silicon and photoresist obtained under the etching condition A were lower than those obtained in both the etching conditions B and C. Namely, the selective

4

etching ability of the etchant gas of $CCl_4$ and $BCl_3$ under the etching condition A is superior to that of the etchant gases under the etching conditions B and C.

Experiment 6

In order to investigate the relationship between aluminium etchrate nonuniformities across aluminium films and the total pressures of etchant gases, a high purity aluminium film formed on a silicon wafer, having a diameter of 3 inches (7.5 cm), was etched in the same plasum etching apparatus under the six conditions in Table 1.

TABLE 1
Etching conditions

| Etchant gas | Total pressure of etchant gas ($\bar{P}$) (Pa) | Symbol in Fig. 6 |
|---|---|---|
| a $CCl_4+BCl_3$ | 33.3 | Triangle and solid line |
| b $CCl_4+BCl_3$ | 26.7 | White circle and solid line |
| c $CCl_4+BCl_3$ | 20.0 | Black circle and solid line |
| d $PCl_3+BCl_3$ | 33.3 | Triangle and broken line |
| e $PCl_3+BCl_3$ | 26.7 | White circle and broken line |
| f $PCl_3+BCl_3$ | 20.0 | Black circle and broken line |

Common factors of the etching conditions were that the RF power was 1 KW and the ratio of partial pressure of $CCl_4$ or $PCl_3$ to the total pressure of each of the etchant gases was 0.5.

The aluminium etchrate was measured at three points a, b and c of the aluminium film, having a diameter of 3 inches, after the dry etching. The point b was the center of the aluminium film, and the points a and c were at a distance of approximately 2.9 mm from the center point b, while the points a, b and c were in a straight-line.

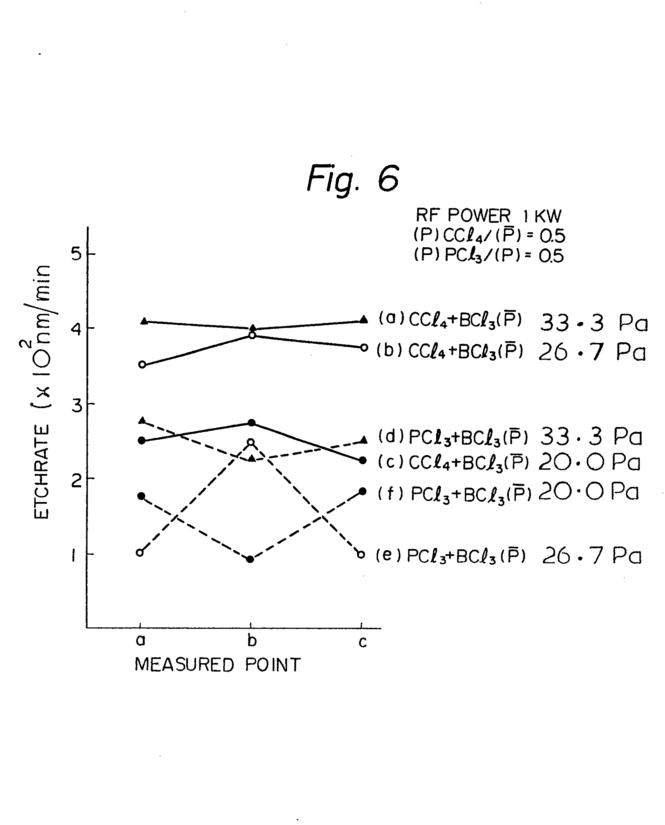

The results of the Experiment 6 are shown in Fig. 6. As is evident from Fig. 6, the aluminium etchrate nonuniformities obtained by using the etchant gas of $CCl_4$ and $BCl_3$ were smaller than those obtained by using the etchant gas of $PCl_3$ and $BCl_3$.

Experiment 7

In order to investigate the relationship between aluminium etchrate nonuniformities across aluminium films and the partial pressure of $CCl_4$ or $PCl_3$ of etchant gases, a high purity aluminium film which was the same as that in Experiment 6 was etched in the plasma etching apparatus used in Experiment 1 under the five conditions in Table 2.

TABLE 2
Etching conditions

| Etchant gas | Ratio of partial pressure of $CCl_4$ or $PCl_3$ to total pressure | Symbol in Fig. 7 |
|---|---|---|
| g $CCl_4+BCl_3$ | 0.6 | Triangle and solid line |
| h $CCl_4+BCl_3$ | 0.5 | White circle and solid line |
| i $CCl_4+BCl_3$ | 0.4 | Black circle and solid line |
| j $PCl_3+BCl_3$ | 0.5 | White circle and broken line |
| h $PCl_3+BCl_3$ | 0.4 | Black circle and broken line |

Common factors of the etching conditions were that the RF power was 1 KW and the total pressure of each of the etchant gases was 26.7 Pa.

The aluminium etchrate was measured at the three points a, b and c of the aluminium film, which were the same points as explained in Experiment 6.

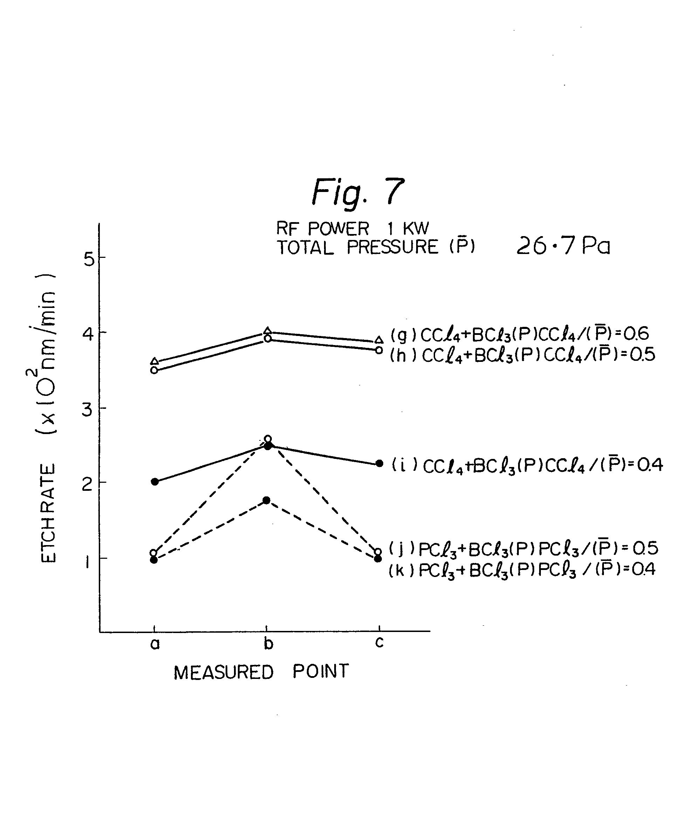

The results of Experiment 7 are shown in Fig. 7. As is evident from Fig. 7, the aluminium etchrate nonuniformities obtained by using the etchant gas of $CCl_4$ and $BCl_3$ were smaller than those obtained by using the etchant gas of $PCl_3$ and $BCl_3$.

Experiment 8

The structure of specimens to be etched consisted of a silicon single crystalline wafer, a silicon dioxide ($SiO_2$) film having a thickness of 400 nm , a high purity aluminium film having a thickness of 1000 nm and an aluminium oxide ($AlO_x$, wherein x was in the range of 1 through 2) film having a thickness of 90 nm. The silicon dioxide film was formed by thermally oxidizing the surface of the silicon wafer and the aluminium film was formed on the silicon dioxide film by vacuum evaporation. Then, the aluminium film was oxidized by anodic oxidation to form the aluminium oxide film comprised of $Al_2O_3$. The specimens having the above-mentioned structure were etched in the plasma etching apparatus used in Experiment 1 under the following three conditions A, B' and C.

The Etching Conditions A and C were the same as the Etching Conditions A and C in Experiment 5, respectively. The etching condition B' was the same as the Etching Condition B in the Experiment 5, except that the partial pressure ratio of $CCl_4$ was 0.5.

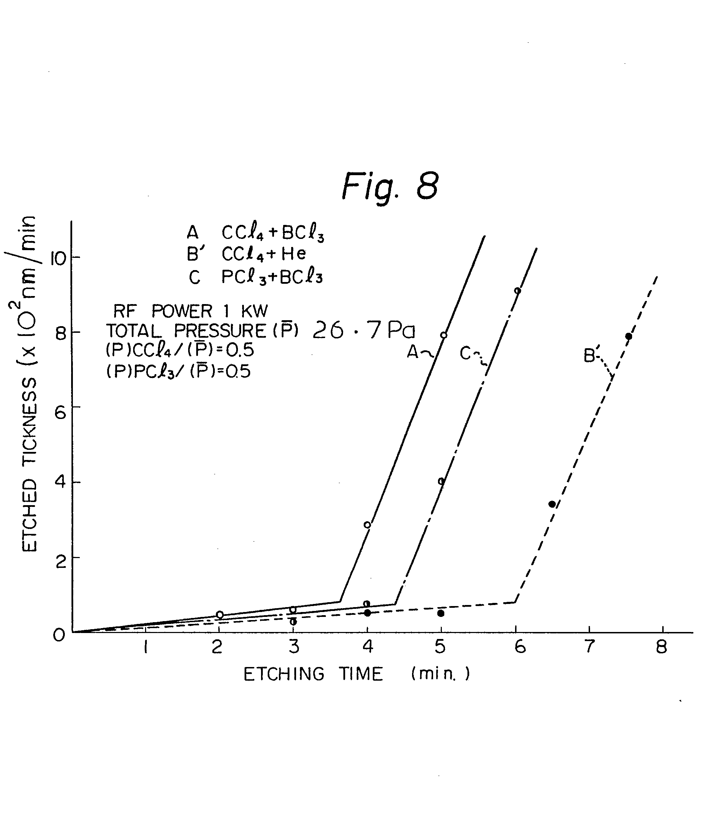

The results of Experiment 8 are shown in Fig. 8. As is evident from Fig. 8, the aluminium oxide layer can be etched most rapidly in the etching condition A among the three etching conditions. Namely, the etchant gas of $CCl_4$ and $BCl_3$ can etch more rapidly than both the etchant gas of $PCl_3$ and $BCl_3$ and the etchant gas of $CCl_4$ and He.

Experiment 9

In order to investigate the amount of undercutting of a metal film to be etched under various conditions, samples to be etched were produced in the following manner. The same type of silicon single crystalline wafer as used in Experiment 8 was thermally oxidized to form a silicon dioxide ($SiO_2$) film having a thickness of 400 nm. On the silicon dioxide film a metal film of aluminum or aluminium-4 wt.% copper having a thickness of 1 micron-meter was formed by vacuum evaporation. A negative type photoresist (OMR-83) having a thickness of approximately 1000 nm was applied on the metal film, exposed and developed to form a predetermined masking pattern. The obtained samples were etched to attain 50% overetching in the plasma etching apparatus used in the Experiment 1 under the following conditions, wherein the mixing ratio of each etchant gas was varied.

Etchant gas: $CCl_4+BCl_3$, $PCl_3+BCl_3$ or $CCl_3+He$
Total pressure of etchant gas: 26.7 Pa
RF power: 1 KW.

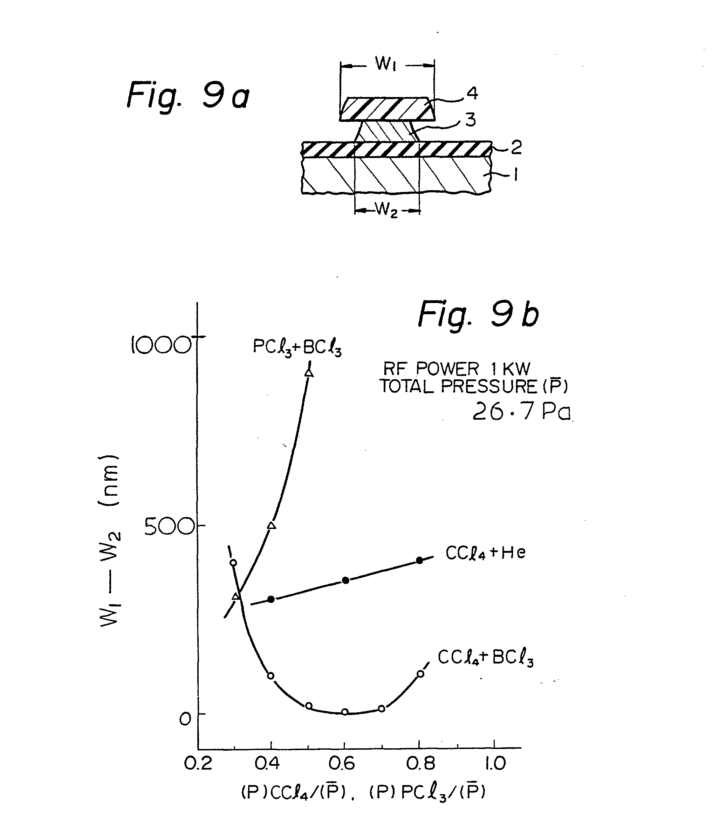

A portion of one of the overetched samples is illustrated in the sectional view of Fig. 9a. In Fig. 9a, a silicon dioxide film 2 is on top of a silicon wafer 1, an etched metal film 3 is on top of the silicon dioxide film 2 and a patterned photoresist 4 is on top of the metal film 3. An amount of overetching is defined as $W_1$ minus $W_2$, wherein $W_2$ is a width of a conductor line of the overetched metal film 3 and $W_1$ is a width of a line of the patterned photoresist 4.

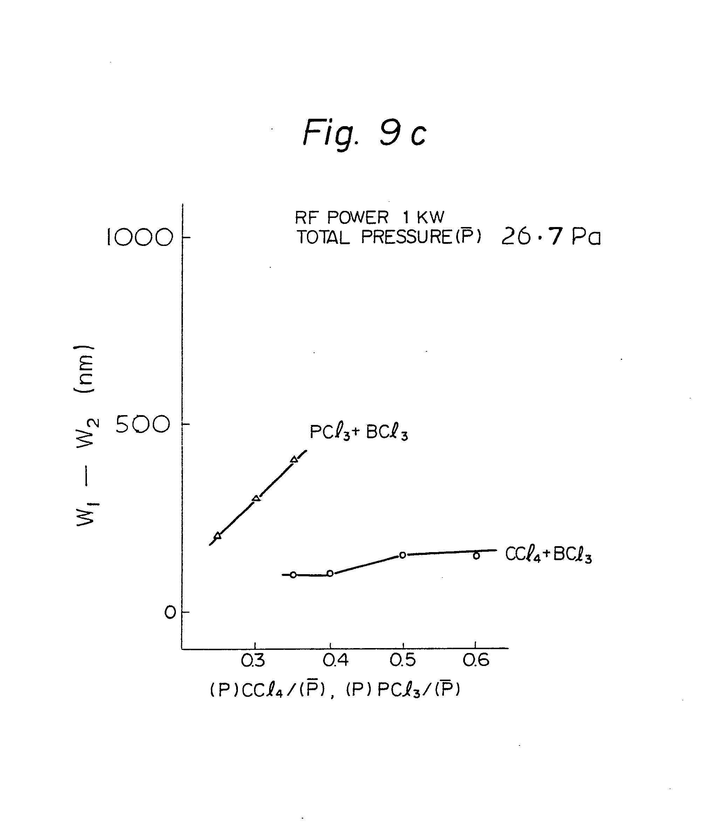

The results of the Experiment 9, wherein aluminium was used as the metal film material are shown in Fig. 9b, and the results of the Experiment 9 wherein aluminium-copper was used as the metal material are shown in Fig. 9c. As is evident from Figs. 9b and 9c, the amount of overetching obtained by using the etchant gas of $CCl_4$ and $BCl_3$ is smaller than that obtained by using both the etchant gas $PCl_3$ and $BCl_3$ and the etchant gas of $CCl_4$ and He.

As is obvious from the Experiments 1 through 9, in order to dry etch aluminium and aluminium based metal, the use of the mixed gas of $CCl_4$ and $BCl_3$ as an etchant gas is preferable to the use of the mixed gas of $PCl_3$ and $BCl_3$ and the mixed gas of $CCl_4$ and He.

In the above-mentioned Experiments 1 through 9, the gases of $CCl_4$ and $BCl_3$ for the etchant gas of the present invention were introduced into a reaction chamber of the etching apparatus without a carrier gas, respectively. However, it is possible to use an inert gas (Ar or He) as the carrier gas for introduction of $CCl_4$ and $BCl_3$ in the reaction chamber. Also, it is possible to substitute the inert gas for less than one-half of the used amount of $BCl_3$ without decreasing the etching ability of the mixed gas of $CCl_4$ and $BCl_3$.

When a conductor pattern on a semiconductor device is formed by dry etching an aluminium film on a substrate in the production of a semiconductor device, although the mixed gas of $CCl_4$ and $BCl_3$ is used as an etchant gas in accordance with the present invention, undercutting inevitably occurs. In a case where overetching is performed, undercutting increases. In order to prevent undercutting from occurring or to minimize undercutting, it is preferable to form an aluminium oxide $(AlO_x)$ film on the surface of the aluminium film by a treatment in water after at least one-half of the aluminium film etching in the course of the dry etching.

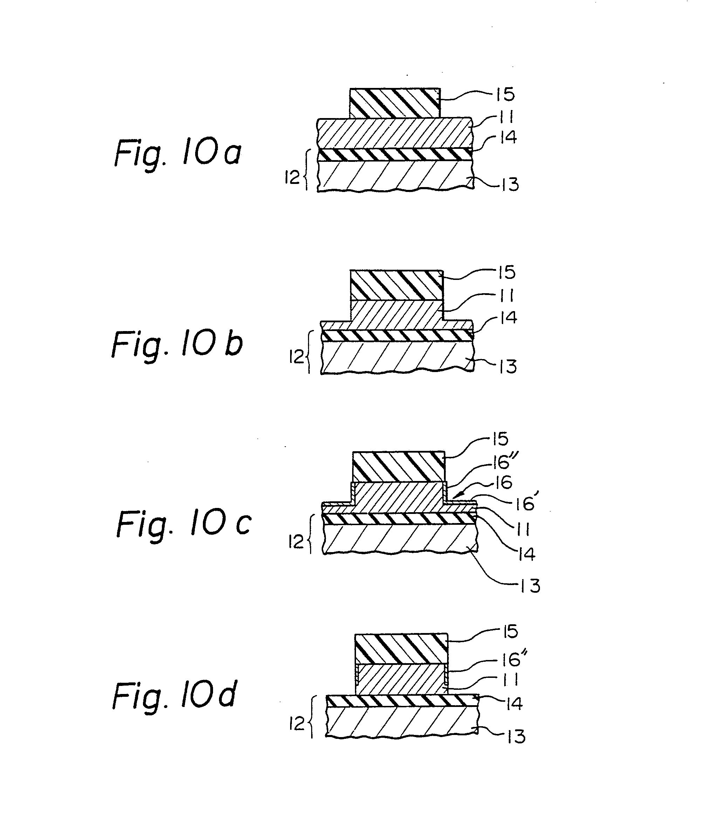

Referring now to Figs. 10a through 10d, the dry etching process of an aluminium film on a semiconductor chip is explained. In the process, an aluminium film 11 is formed by vacuum evaporation or any other suitable technique on the surface of a semiconductor chip 12. The semiconductor chip 12 comprises a semiconductor substrate 13, e.g. a silicon single crystalline wafer, and an insulating film 14, e.g. a silicon dioxide film, which covers the surface of the substrate 13. A photoresist masking film 15 is applied on the surface of the aluminium film 11, exposed and developed to form a predetermined pattern, as illustrated in Fig. 10a. The aluminium film 11 on the semiconductor chip 12 is selectively etched in a dry etching apparatus, e.g. a plasma etching apparatus or a reactive ion etching apparatus, which have almost the same construction, by using the mixed gas $CCl_4$ and $BCl_3$ as the etchant gas to remove one-half to three-fourths of the unmasked portion of the aluminium film 11, as illustrated in Fig. 10b. It is preferable that the etchant gas consist of $CCl_4$ and $BCl_3$, but it is possible to add an inert gas, i.e. Ar or He, to the mixed gas of $CCl_4$ and $BCl_3$. A preferred partial pressure of the inert gas is less than 60 percent of the total pressure.

The semiconductor chip 12 is, then, taken out of the etching apparatus, and is treated with water, namely, is washed with water or is placed in a boiling water bath, to form an aluminium oxide film 16 comprising of $Al_2O_3$ on the exposed surface of the aluminium film 11, as illustrated in Fig. 10c. A preferred thickness of the aluminium oxide film 16 is in the range of 10 to 100 nm.

The aluminium film 11 with the aluminium oxide film 16 is reetched in the same etching apparatus by using the mixed gas of $CCl_4$ and $BCl_3$. In the reetching step, the etchrate of a horizontal portion 16' of the aluminium oxide film 16 is higher than that of a vertical portion 16'' thereof, since a generated chemical sputtering effect of the horizontal portion 16' is stronger than that of the vertical portion 16''. Furthermore, since the aluminium etchrate is higher than the aluminium oxide etchrate, the portion of aluminium film which is not covered with the photoresist 15 is removed, as illustrated in Fig. 10d. Accordingly, it is possible to obtain a conductor pattern of aluminium without undercutting or with very small undercutting.

In a case where an aluminium-copper film or an aluminium-silicon film, instead of the aluminium film, is dry etched to form a conductor pattern of a semiconductor device, copper or silicon residues accumulate as the dry etching proceeds. The accumulated residues prevent the etching from proceeding further and, as the result, the required etching period lengthens and the undercutting increases. In order to prevent the etching period from lengthening and to minimize the undesired undercutting, it is preferable to remove the copper or silicon residues by a suitable remover, and then, to form a thin aluminium oxide film on the exposed surface of the aluminium-copper film or aluminium-silicon film in the course of the dry etching.

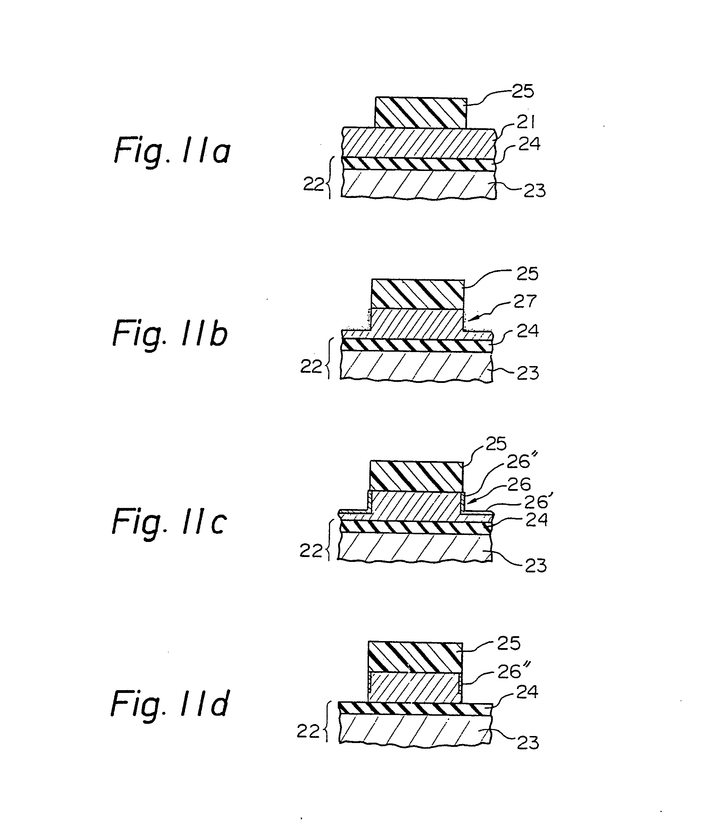

Referring to Fig. 11a through 11d, the dry etching process of an aluminium-copper or aluminium-silicon film on a semiconductor chip will now be explained. In the process, an aluminium based film 21 of either aluminium-copper or aluminium-silicon is formed on the surface of a semiconductor chip 22 by vacuum evaporation or any other suitable technique. The semiconductor chip 22 comprises a semiconductor substrate 23 and an insulating film 24, which are the same as the semiconductor substrate 13 and the insulating film 14, respectively. A photoresist masking film 25 is applied on the surface of the aluminium based metal 21, exposed and developed to form a pattern, as illustrated in Fig. 11a. The aluminium based film 21 is selectively etched in a plasma etching apparatus or a reactive ion etching apparatus by using the mixed gas of $CCl_4$ and $BCl_3$ to remove one-half to three-fourths of the unmasked portion of the aluminium film 21, as illustrated in Fig. 11b. After this etching, copper or silicon residues 27 remain on the etched aluminium based metal 21.

The semiconductor chip 22 is taken out of the etching apparatus and, then, the copper or silicon residues 27 are removed by nitric acid (HNO$_3$) solution or carbon tetrafluoride and oxygen (CF$_4$+5%O$_2$) plasma which is generated under a condition, e.g. at 66.7 Pa, 500 watts, for 1 minute. Thereafter, the exposed surface of the aluminium based film 21 is washed with water. Such treatment in water forms an aluminium oxide (AlO$_x$) film 26 on the exposed surface of the aluminium based film 21, as illustrated in Fig. 11c. A preferred thickness of the aluminium oxide film 26 is in the range of from 10 to 30 nm.

The aluminium based film 21 with the aluminium oxide film 26 consisting of a horizontal portion 26' and a vertical portion 26″ is reetched in the same etching apparatus by using the mixed gas of CCl$_4$ and BCl$_3$. Since the reetching preceeds in the same manner as the above-mentioned reetching of the aluminium film, the portion of aluminium based film 21 which is not covered with the photoresist 25 is removed, as shown in Fig. 11d. Accordingly, it is possible to obtain a conductor pattern of aluminium-copper or aluminium-silicon without undercutting or with very small undercutting.

### Claims

1. A process for dry etching an aluminium film or an aluminium based metal film, comprising the step of exposing the film to an etchant gas, characterised in that the etchant gas is a mixture of carbon tetrachloride and boron trichloride, or a mixture of carbon tetrachloride, boron trichloride and an inert gas as a carrier, the amount of inert gas being less than one half of the amount of boron trichloride.

2. A process as claimed in claim 1, characterised in that the partial pressure of said carbon tetrachloride is in the range of from 30 to 80 percent of the total pressure of the gas mixture.

3. A process as claimed in claim 1 or 2, characterised in that the etchant gas has a pressure in the range of from 13.3 to 33.3 Pa.

4. A process as claimed in claim 1, 2 or 3, characterised in that the exposing step is performed by exciting the etchant gas at an RF power in the range of from 400 to 1000 watts.

5. A process for forming a fine conductor pattern of aluminium on a silicon chip (13) provided with a silicon dioxide film (14) and in which a patterned masking film (15) of photoresist is formed on the metal film, characterised in that the metal film (11) is exposed to a mixed etchant gas of carbon tetrachloride and boron trichloride, or of carbon tetrachloride, boron trichloride and inert gas, to remove at least one half of the unmasked portion of the metal film, an aluminium oxide film (16, 16') is formed on the exposed surface of the metal film by a treatment in water, and the exposing step is repeated in the etchant gas to remove the horizontal portion of the aluminium oxide film (16') and the rest of the unmasked portion of the metal film lying under the horizontal portion of the aluminium oxide film.

6. A process for forming a fine conductor pattern of aluminium based metal on a silicon chip (23) provided with a silicon dioxide film (24) and in which a patterned masking film (25) of photoresist is formed on the metal film, characterised in that the metal film (21) is exposed to a mixed etchant gas of carbon tetrachloride and boron trichloride, or carbon tetrachloride, boron trichloride and inert gas, to remove at least one half of the unmasked portion of the metal film and to accumulate residues (27) of the metal film, the residues are removed by a remover, the aluminium oxide film is formed (26, 26') on the exposed surface of said metal film by a treatment in water, and repeating said exposing step to remove the horizontal portion of said aluminium oxide film (26') and the rest of said unmasked portion of the metal film lying under said horizontal portion of the aluminium oxide film.

### Revendications

1. Procédé permettant d'inciser à sec une pellicule d'aluminium ou une pellicule de métal à base d'aluminium, comprenant l'opération qui consiste à exposer la pellicule à un gaz d'incision, caractérisé en ce que le gaz d'incision est un mélange de tétrachlorure de carbone et de trichlorure de bore, ou un mélange de tétrachlorure de carbone, de trichlorure de bore et d'un gaz inerte faisant fonction de support, la quantité de gaz inerte étant inférieure à la moitié de la quantité de trichlorure de carbone.

2. Procédé selon la revendication 1, caractérisé en ce que la pression partielle dudit tétrachlorure de carbone est dans l'intervalle de 30 à 80% de la pression totale du mélange gazeux.

3. Procédé selon la revendication 1 ou 2, caractérisé en ce que le gaz d'incision a une pression comprise entre 13,3 et 33,3 Pa.

4. Procédé selon la revendication 1, 2 ou 3, caractérisé en ce que l'opération d'exposition est effectuée par excitation du gaz d'incision sous une puissance RF comprise entre 400 et 1 000 W.

5. Procédé permettant de former une fine configuration conductrice d'aluminium sur une puce semiconductrice (13) dotée d'une pellicule de dioxyde de silicium (14) et où une pellicule de masquage configurée (15) en vernis photosensible est formé sur la pellicule métallique, caractérisé en ce que l'on expose la pellicule métallique (11) à un mélange de gaz d'incision fait de tétrachlorure de carbone et de trichlorure de bore ou de tétrachlorure de carbone, de trichlorure de bore et d'un gaz inerte, afin d'enlever au moins la moitié de la partie non masquée de la pellicule métallique, on forme une pellicule d'oxyde d'aluminium (16, 16') à la surface exposée de la pellicule métallique par traitement dans l'eau, et on répète l'opération d'exposition dans le gaz d'incision afin d'enlever la partie horizontale de la pellicule d'oxyde

**0 023 429**

d'aluminium (16') et le reste de la partie non masquée de la pellicule métallique se trouvant sous la partie horizontale de la pellicule d'oxyde d'aluminium.

6. Procédé de formation d'une fine configuration conductrice d'un métal à base d'aluminium sur une puce de silicium (23) dotée d'une pellicule de dioxyde de silicium (24) et où une pellicule de masquage configurée (25) en vernis photosensible est formée sur la pellicule métallique, caractérisé en ce que l'on expose la pellicule métallique (21) à un mélange de gaz d'incision fait de tétrachlorure de carbone et de trichlorure de bore, ou de tétrachlorure de carbone, de trichlorure de bore et d'un gaz inerte, afin d'enlever au moins une moitié de la partie non masquée de la pellicule métallique et de faire s'accumuler des résidus (27) de la pellicule métallique, on enlève les résidus à l'aide d'un agent d'enlèvement, on forme la pellicule d'oxyde d'aluminium (26, 26') à la surface exposée de ladite pellicule métallique par un traitement dans l'eau, et on répète ladite opération d'exposition afin d'enlever la partie horizontal de ladite pellicule d'oxyde de silicium (26') et le reste de ladite partie non masquée de la pellicule métallique se trouvant sous ladite partie horizontale de la pellicule d'oxyde d'aluminium.

**Patentansprüche**

1. Verfahren zur trockenen Ätzung eines Aluminiumfilms oder eines auf Aluminium basierenden Metallfilms, bei welchem während eines Schritts der Film einem ätzenden Gas exponiert wird, dadurch gekennzeichnet, daß das ätzende Gas eine Mischung aus Kohlenstofftetrachlorid und Bortrichlorid oder eine Mischung aus Kohlenstofftetrachlorid, Bortrichlorid und einem inerten Gas als Träger ist, wobei die Menge an inertem Gas geringer als die halbe Menge des Bortrichlorids ist.

2. Verfahren nach Anspruch 1, dadurch gekennzeichnet, daß der Teildruck des genannten Kohlenstofftetrachlorids im Bereich von 30 bis 80% des Gesamtdrucks der Gasmischung ist.

3. Verfahren nach Anspruch 1 oder 2, dadurch gekennzeichnet, daß das ätzende Gas einen Druck im Bereich von 13,3 bis 33,3 Pa hat.

4. Verfahren nach Anspruch 1, 2 oder 3, dadurch gekennzeichnet, daß der Expositionsschritt durch Anregung des ätzenden Gases bei einer RF-Leistung in dem Bereich von 400—1000 Watt durchgeführt wird.

5. Verfahren zur Bildung eines feinen Halbleitermusters aus Aluminium auf einem Siliziumchip (13), welcher einen Siliziumdioxidfilm (14) aufweist und in welchem ein gemusterter Maskierungsfilm (15) aus Fotoresist auf dem Metallfilm gebildet wird, dadurch gekennzeichnet, daß der Metallfilm einem gemischten Ätzgas aus Kohlenstofftetrachlorid und Bortrichlorid oder aus Kohlenstofftetrachlorid, Bortrichlorid und inertem Gas exponiert wird, um wenigstens eine Hälfte des unmaskierten Abschnitts des Metallfilms zu entfernen, ein Aluminiumoxidfilm (16, 16') auf der exponierten Oberfläche des Metallfilms durch eine Behandlung in Wasser gebildet wird und der Expositionsschritt in dem Ätzgas wiederholt wird, um den horizontalen Abschnitt des Aluminiumoxidfilms (16') und den Rest des unmaskierten Abschnitts des Metallfilms, der unter dem horizontalen Abschnitt des Aluminiumoxidfilms liegt, zu entfernen.

6. Verfahren zur Bildung eines feinen Halbleitermusters aus auf Aluminium basierenden Metall auf einem Siliziumchip (23), der mit einem Siliziumdioxidfilm (24) versehen ist und in dem ein gemusterter Maskierungsfilm (25) aus Fotoresist auf dem Metallfilm gebildet wird, dadurch gekennzeichnet, daß der Metallfilm (21) einem gemischten Ätzgas aus Kohlenstofftetrachlorid und Bortrichlorid, oder Kohlenstofftetrachlorid, Bortrichlorid und inertem Gas exponiert wird, um wenigstens eine Hälfte des unmaskierten Abschnitts des Metallfilms zu entfernen und Reste (27) des Metallfilms zu akkumulieren, die Reste durch einen Entferner entfernt werden, der Aluminiumoxidfilm (26, 26') auf der exponierten Oberfläche des genannten Metallfilms durch eine Behandlung in Wasser gebildet wird und der Expositionsschritt wiederholt wird, um den horizontalen Abschnitt des genannten Aluminiumoxidfilms (26') und den Rest des unmaskierten Abschnitts des Metallfilms, der unter dem genannten horizontalen Abschnitt des Aluminiumoxidfilms liegt, zu entfernen.

9

# Fig. 1

RF POWER 1 KW
TOTAL PRESSURE ($\bar{P}$)  26.7 Pa

# Fig. 2

TOTAL PRESSURE (P̄)  26·7 Pa
(P) $CCl_4$ / (P̄) = 0.5
(P) $PCl_3$ / (P̄) = 0.5

# Fig. 3

RF POWER 1 KW
$(P)CCl_4/(\bar{P}) = 0.5$
$(P)PCl_3/(P) = 0.5$

# Fig. 4

RF POWER 1 KW
TOTAL PRESSURE $(\bar{P})$ 26·7 Pa

$CC\ell_4 + BC\ell_3$

$PC\ell_3 + BC\ell_3$

ETCHRATE $(\times 10^2 \, nm \, / min)$

$(P)CC\ell_4 / (\bar{P})$, $(P)PC\ell_3 / (\bar{P})$

Fig. 5

A: $CCl_4 + BCl_3$ (P)$CCl_4$/($\bar{P}$)=0.5
B: $CCl_4 + He$ (P)$CCl_4$/($\bar{P}$)=0.7
C: $PCl_3 + BCl_3$ (P)$PCl_3$/($\bar{P}$)=0.5

RF POWER 1000W
TOTAL PRESSURE($\bar{P}$) 26·7 Pa

# Fig. 6

RF POWER 1 KW
(P) $CCl_4/(\bar{P})$ = 0.5
(P) $PCl_3/(P)$ = 0.5

(a) $CCl_4+BCl_3(\bar{P})$ 33·3 Pa
(b) $CCl_4+BCl_3(\bar{P})$ 26·7 Pa

(d) $PCl_3+BCl_3(\bar{P})$ 33·3 Pa
(c) $CCl_4+BCl_3(\bar{P})$ 20·0 Pa
(f) $PCl_3+BCl_3(\bar{P})$ 20·0 Pa

(e) $PCl_3+BCl_3(\bar{P})$ 26·7 Pa

ETCHRATE ($\times 10^2$ nm/min)

MEASURED POINT

*Fig. 7*

RF POWER 1 KW
TOTAL PRESSURE ($\bar{P}$)    26·7 Pa

(g) $CCl_4+BCl_3$(P)$CCl_4/(\bar{P})$=0.6
(h) $CCl_4+BCl_3$(P)$CCl_4/(\bar{P})$=0.5

(i) $CCl_4+BCl_3$(P)$CCl_4/(\bar{P})$=0.4

(j) $PCl_3+BCl_3$(P)$PCl_3/(\bar{P})$=0.5
(k) $PCl_3+BCl_3$(P)$PCl_3/(\bar{P})$=0.4

ETCHRATE ($\times 10^2$ nm/min)

MEASURED POINT

7

# Fig. 8

A   $CC\ell_4 + BC\ell_3$
B'  $CC\ell_4 + He$
C   $PC\ell_3 + BC\ell_3$

RF  POWER 1 KW
TOTAL PRESSURE $(\bar{P})$ $26\cdot7$ Pa
$(P)CC\ell_4/(\bar{P})=0.5$
$(P)PC\ell_3/(\bar{P})=0.5$

ETCHED TICKNESS $(\times 10^2 nm/min)$

ETCHING TIME   (min.)

Fig. 9a

Fig. 9b

RF POWER 1 KW
TOTAL PRESSURE ($\bar{P}$)
26·7 Pa

# Fig. 9c

RF POWER 1 KW
TOTAL PRESSURE ($\bar{P}$) 26·7 Pa

PC$l_3$+ BC$l_3$

CC$l_4$+BC$l_3$

$W_1 - W_2$ (nm)

1000

500

0

0.3   0.4   0.5   0.6

(P)CC$l_4$/($\bar{P}$) , (P) PC$l_3$/($\bar{P}$)

*Fig. 10 a*

*Fig. 10 b*

*Fig. 10 c*

*Fig. 10 d*

Fig. IIa

Fig. IIb

Fig. IIc

Fig. IId